# EUROPEAN PATENT APPLICATION

(11) **EP 1 841 301 A2**
(43) Date of publication of application: **03.10.2007**
(21) Application number: 07251341.9
(22) Date of filing: 28.03.2007
(51) Int. Cl.: H05K 3/10, H05K 3/12

(54) **System and method for making printed electronic circuits**

(30) Priority: 31.03.2006 US 394436
(71) Applicant: WEYERHAEUSER COMPANY, Federal Way, WA 98063-9777 (US)
(72) Inventor: Hirahara, Edwin, Federal Way, Washington 98023 (US); Lee, David L., Tacoma, Washington 98407 (US); Spencer, Paul R., Pullman, Washington 99163 (US); Bunce, Richard, Boise, Idago 83706 (US)
(74) Representative: Bayliss, Geoffrey Cyril

(57) **Abstract**

A method and system (80) are provided for printing an electronic device (116, 118, 120) onto a substrate (40) using electrophotography (EP). The method includes generally three steps. First, a surface is provided, such as a substrate (40) (e.g. paper, plastic film, etc.) on which the electronic device is to be printed. Second, the surface is routed through a sequential series of EP print stations (70A-70C). Each of the EP print stations consists of an electrostatically chargeable drum or plate (10) and at least a portion of one surface support structure (e.g. a transfer roller, platen, etc.), wherein each electrostatically chargeable drum or plate defines a positive image (110) formed of charged particles. Third, the positive images (110) defined on the electrostatically chargeable drums or plates of the series of EP print stations are sequentially transferred onto the surface. Each of the positive images represents an image layer for forming the electronic device. Thus, the sequential transferring of the positive images onto a substrate forms the electronic device (116, 118, 120) on the substrate (40).

## Description

The present invention is directed generally to printing electronic circuits, and more particularly, to producing printed electronic circuits using electrophotography (or xerography).

Printed electronics may be viewed as an extension of the well known printed circuit board technology. A printed circuit board includes a substrate with conductive metal paths for wiring. All other electronic components are made separately and are soldered or clamped to the substrate of the printed circuit board. In more recent developments, semiconductor integrated circuits are produced to perform most electronic circuit functions. Production of integrated circuits, however, requires the use of specialized semiconductor substrates and is expensive and impractical for producing low-cost electronic devices. For example, typically, the cost of integrated circuits cannot be lowered significantly, and even a relatively low level of cost cannot be achieved unless the integrated circuits are produced in a very high volume.

Printed electronics arc formed by printing images layer by layer, i.e., by depositing one or more layers of material, on a wide variety of substrates including uncoated or coated paper, laminated paper products, various plastic films such as polyethylene or polynaphthalene, etc. With printed electronics technology, it is possible to produce micro-electric components of an electronic circuit. Some examples of micro-electric components that may he produced include transistors, capacitors, resistors, diodes, and light emitting diodes, while examples of complete circuits include RFID tags, sensors, flexible displays, etc. As an example, a capacitor can be constructed by depositing a conducting area, fallowed by depositing a larger insulating layer and then another conducting area. This process can be repeated to obtain higher capacitance. As another example, a transistor can be formed by depositing a conductor layer forming source and drain electrodes, a semiconductor layer, a dielectric layer, and another conductor layer forming a gate electrode.

Especially when low-cost conducting and semiconducting materials, such as organic polymers, are used as the materials to be deposited, printed electronics forming complete functional circuits (e.g., RFID tags) may be produced at a very low cost on the order of about one tenth of the cost of producing analogous integrated circuits. Such low-cost printed electronics are not expected to compete directly with silicon-based integrated circuits. Rather, printed electronics circuits may be produced to offer lower performance (e.g., lower frequency, lower power, or shorter lifetime) at much lower cost as compared to silicon-based integrated circuits.

Printed electronics components are made using a set of materials, typically 5 to 7 different materials. These are usually liquids with dissolved and/or suspended polymers, polymer precursors, inorganic materials, and organic or inorganic additives, and are deposited in a wet printing process. Specifically, these materials are deposited in a desired sequence on a substrate and are often cured or activated by a thermal cycling and/or humidity treatment. Typical wet printing methods include letterpress printing, screen printing, and ink jet printing.

The present invention is directed to providing a system and method using a "dry" printing process for making printed electronic circuits. Currently, as far as the inventors of the present application are aware, no dry printing process suitable for producing printed electronics is known in the art.

This summary is provided to introduce a selection of concepts of the present invention in a simplified form that are further described below in the Detailed Description. This summary is not intended to identify key features of the claimed subject matter, nor is it intended to be used as an aid in determining the scope of the claimed subject matter.

In accordance with one embodiment of the present invention, a method is provided for printing an electronic device onto a substrate using electrophotography (EP). The method includes generally three steps. First, a surface is provided. For example, the surface may be a substrate (e.g., paper, plastic film, etc.) on which the electronic device is to be printed. Second, the surface (e.g., the substrate) is routed through a sequential series of EP print stations. Each of the EP print stations generally consists of an electrostatically chargeable drum or plate and at least a portion of one surface support structure (e.g., a transfer roller, platen, etc.), wherein each electrostatically chargeable drum or plate defines a positive image formed of charged particles. Third, the positive images defined on the electrostatically chargeable drums or plates of the series of EP print stations are sequentially transferred onto the surface. Each of the positive images represents an image layer for forming the electronic device. Thus, the sequential transferring of the positive images onto a substrate forms the electronic device on the substrate.

In accordance with another aspect of the present invention, the charged particles are micro- or nano-encapsulated particles. The encapsulated particles may be any of conductive materials, semiconductive materials, and insulative materials, and further may be polymeric or non-polymeric materials.

In accordance with yet another aspect of the present invention, the surface onto which the positive images are sequentially transferred from the series of EP print stations may be an intermediate surface, from which the positive images are further sequentially transferred onto a substrate on which the electronic device is to be formed.

In accordance with still another aspect of the present invention, the electrostatically chargeable drum or plate may be formed of photoconductor. Alternatively, the electrostatically chargeable drum or plate may he formed of a dielectric-coated surface topography formed by photolithography.

In accordance with another embodiment of the present invention, a system is provided for printing an electronic device onto a substrate using electrophotography (EP). The system includes a series of EP print stations, wherein each EP print station includes an electrostatically chargeable drum or plate and at least a portion of one surface support structure. Each electrostatically chargeable drum or plate defines a positive image formed of charged particles, and each positive image represents an image layer that forms the electronic device. The system also includes one or more motors for powering the electrostatically chargeable drums or plates of the series of EP print stations. The system further includes an EP print control system, which controls the plurality of EP print stations and the one or more motors so as to move a surface (e.g., a substrate) through the series of EP print stations and to sequentially transfer the positive images defined on the electrostatically chargeable drums or plates of the series of EP print stations onto the surface.

In accordance with yet another embodiment of the present invention, a method is provided for printing a plurality of print layers using electrophotography (EP), including generally four steps. First, a surface is routed to a first EP print station, wherein the first EP print station includes a first electrostatically chargeable drum or plate and at least a portion of one surface support structure, and the first electrostatically chargeable drum or plate defines a first positive image formed of charged particles. Second, the first positive image defined on the first electrostatically chargeable drum or plate of the first EP print station is transferred onto the surface. Third, the surface is routed to a second EP print station, wherein the second EP print station includes a second electrostatically chargeable drum or plate and at least a portion of one surface support structure, and the second electrostatically chargeable drum or plate defines a second positive image formed of charged particles. Fourth, the second positive image defined on the second electrostatically chargeable drum or plate of the second EP print station is transferred onto the surface.

The foregoing aspects and many of the attendant advantages of this invention will become more readily appreciated as the same become better understood by reference to the following detailed description, when taken in conjunction with the accompanying drawings, wherein:
FIGURES 1A and 1B are schematic diagrams showing the first step of making printed electronic circuits using electrophotography, involving charging an electrostatically chargeable surface made of photoconductor, in accordance with one embodiment of the present invention;
FIGURE 2 is a schematic diagram showing the second step of making printed electronic circuits using electrophotography, involving exposing the charged photoconductor to light to form a latent image, in accordance with one embodiment of the present invention;
FIGURE 3 is a schematic diagram showing the third step of making printed electronic circuits using electrophotography, involving developing a positive image based on the latent image, in accordance with one embodiment of the present invention;
FIGURE 4 is a schematic diagram showing the fourth step of making printed electronic circuits using electrophotography, involving transferring the positive image from the photoconductor to a substrate, in accordance with one embodiment of the present invention;
FIGURE 5 is a schematic diagram showing the fifth step of making printed electronic circuits using electrophotography, involving fusing and curing the positive image to the substrate, in accordance with one embodiment of the present invention;
FIGURE 6 is a schematic diagram showing the sixth step of making printed electronic circuits using electrophotography, involving cleaning the photoconductor for future use, in accordance with one embodiment of the present invention;
FIGURE 7 is a schematic diagram showing a rotating drum, around which all of the six steps of FIGURES 1-6 are carried out simultaneously at different positions, which is suitable for use in a system in accordance with one embodiment of the present invention;
FIGURE 8 is a simplified functional block diagram of an exemplary electrophotographic printing system formed in accordance with the present invention;
FIGURE 9 is a schematic view of one embodiment of the printing system of FIGURE 8;
FIGURES 10A-10C are sample layer images suitable for forming a capacitor, which may be produced by the printing system of FIGURES 8-9B;
FIGURES 11A-11C are side views of a printed electronic device (e.g., a capacitor) being fabricated layer by layer by the printing system of FIGURES 8 -9B;
FIGURE 12 is a side view of a dielectric-coated surface topography formed by photolithography, suitable for providing an electrostatically chargeable surface in accordance with one embodiment of the present invention; and
FIGURE 13 illustrates the use of an intermediate surface (e.g., an intermediate drum) provided between an electrostatically chargeable surface (e.g., a photoconductor drum) and a substrate on which an electronic device is to be printed, in accordance with some embodiments of the present invention.

Embodiments of the present invention will now be described with reference to the accompanying drawings where like numerals correspond to like elements. The following description provides examples of methods and systems for fabricating printed electronic devices using electrophotography (EP) or xerography. The methods and systems of the present invention may also be suitable for use in printing color graphics, or to color, coat, varnish, or apply other surface treatments to a variety of substrates.

EP (or xerography) has been long used in copying machines and laser printers, and its technical principles are well known in the art. Briefly, EP is a dry photographic or photocopying process, in which a positive image formed of charged particles on an electrically charged plate (or drum) is electrically transferred to and fixed as a positive image on a substrate, such as paper. While EP has been known, to the inventors' knowledge, it has not been applied in the past to produce printed electronics. The present invention offers various methods and systems for making printed electronics using EP.

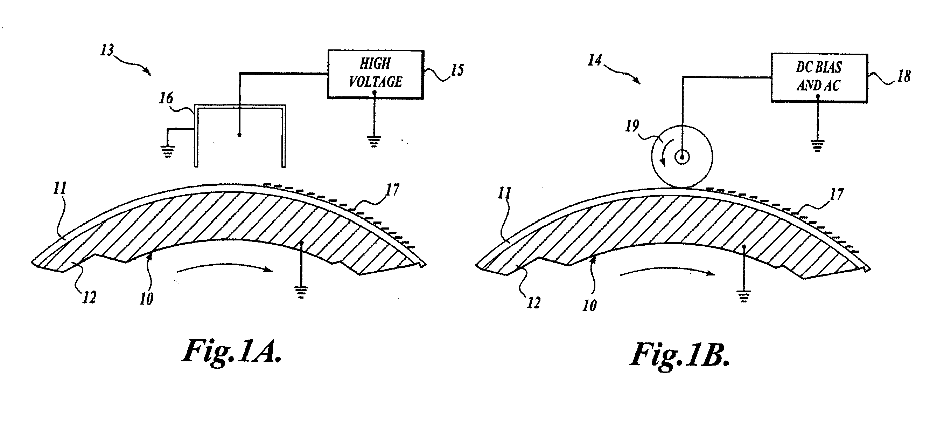

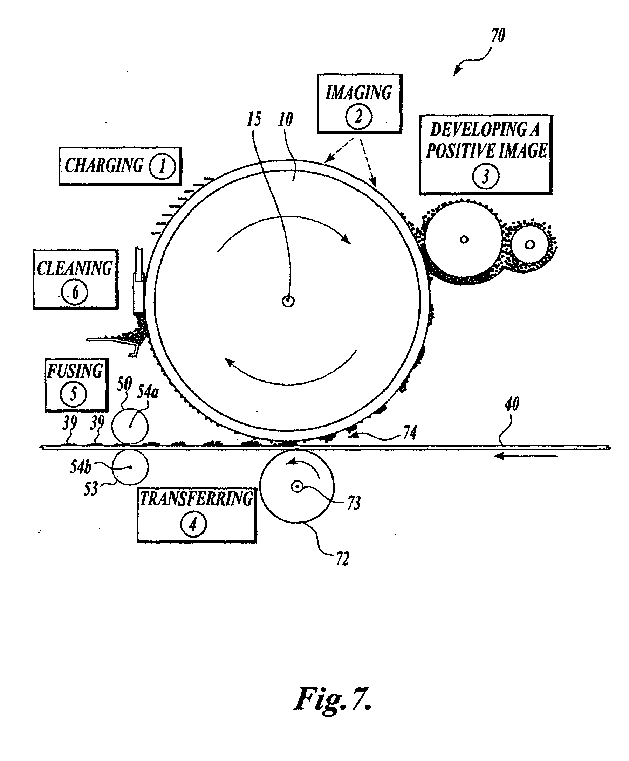

The following first describes the six steps generally required in EP process in reference to FIGURES 1-6, and then describes overall systems and methods for making printed electronics using EP process in reference to FIGURES 7-13.

EP process includes generally six steps: (1) charging a photoconductor, (2) exposing the charged photoconductor to light to form a latent image, (3) developing a positive image on the latent image using the electric charges of the latent image to attract the toner powder, (4) transferring the positive image from the photoconductor to a substrate, (5) fusing and curing the positive image to the substrate, and (6) cleaning the photoconductor for future use.

Referring to FIGURES 1A and 1B, the first step of EP involves charging a photoconductor drum 10. The photoconductor drum 10 (or plate) consists of a photoconductive (i.e., conductive when exposed to light, and insulative in the dark) layer (e.g., coating) 11 and a conductive metal ground layer 12. The photoconductive layer 11 is charged electrostatically by an electrical corona device 13 (FIGURE 1A) or by a charging roller 14 (FIGURE 1 B). Briefly, the electrical corona device 13 generally consists of a high voltage source 15 and a corona discharge device 16. The corona wire of a corona discharge device 16, when subjected to high voltage, causes surrounding air molecules to ionize, to thereby drive charges 17 (negative or positive) onto the photoconductive layer 11. The charging roller 14 of FIGURE 1B generally consists of a DC-bias and AC source 18 and a roller 19, which is again configured to drive changes 17 onto the photoconductive layer 11.

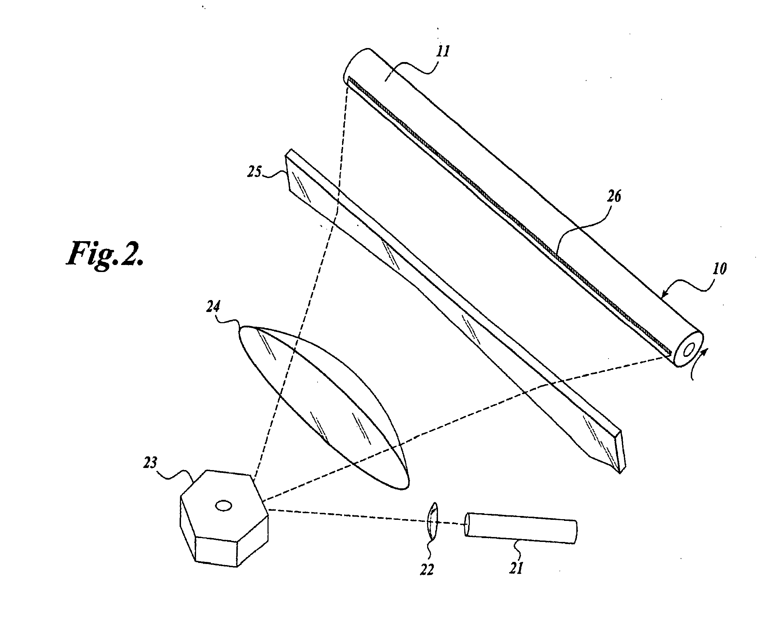

Referring to FIGURE 2, the second step of EP involves exposing the charged photoconductive layer 11 to light to develop an electrostatic latent image. Specifically, the photoconductive layer 11 is exposed to light in some desired pattern. Portions of the photoconductive layer 11 exposed to light become neutralized because the charge in those portions is drained away from the photoconductive layer 11 to the ground layer 12 (see FIGURE 1). On the other hand, portions of the photoconductive layer 11 un-exposed to light remain electrostatically charged, thereby forming an electrostatic latent image of a desired pattern. A light pattern can be applied to the photoconductor drum (or more specifically to the photoconductive layer 11) in various ways, for example, directly by using a scanned laser beam or an LED light bar, or indirectly by first creating a pattern image and then projecting the pattern image onto the photoconductive layer 11. FIGURE 2 illustrates a sample sub-system for this purpose using a scanned laser beam to directly apply a light pattern to the photoconductor drum 10. A laser beam from a laser source 21 is collimated through a lens 22 and is reflected by a rotating scanning polygon 23, to propagate through a combination of a cosine correction lens 24 and a mirror 25 to project a laser-beam exposure line 26 of some desired pattern onto the photoconductive drum 10. This is done by modulating the laser beam intensity to create a desired pattern of charge on the photoconductive drum 10. Because of the small focused diameter of a laser spot, high resolution imaging can be achieved. In producing printed electronics, the areas where printing is desired (i.e., the areas where conductive/semiconductive/insulative materials are to be deposited) are left unexposed to light and electrostatically charged. In other words, a latent image comprised of electrostatically charged areas forms a pattern which will be used to create the circuit layouts for producing printed electronics circuits.

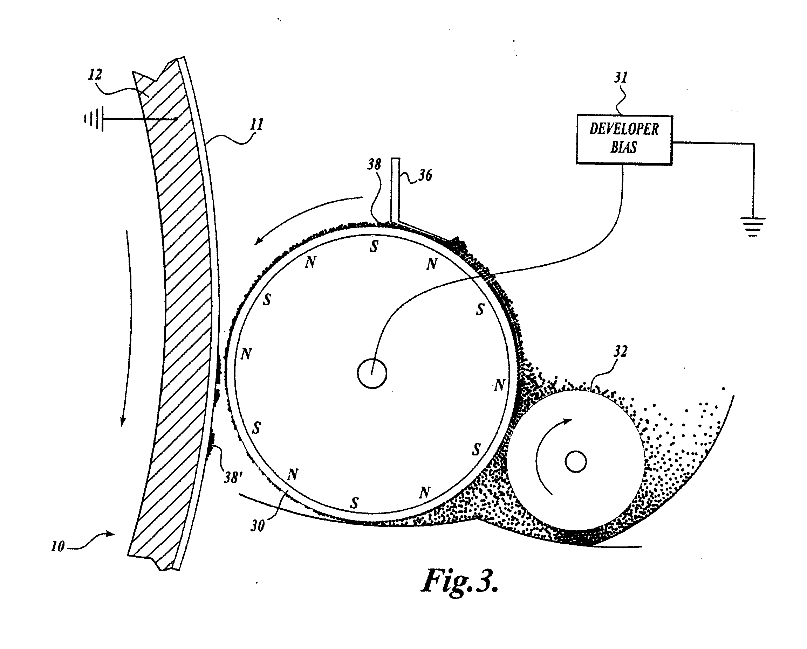

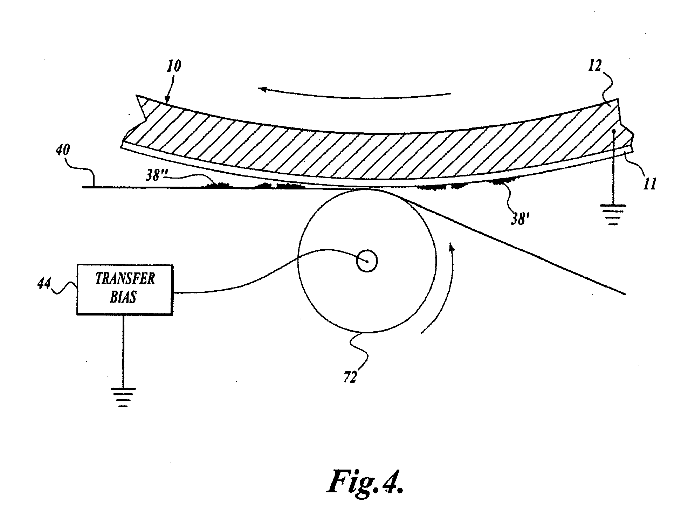

Referring to FIGURE 3, the third step of EP involves developing a positive image based on the electrostatic latent image created in the previous step. The specific development system shown in FIGURE 3 is suitable for use with a developer mixture of magnetic carrier beads (about 100 micrometers or larger in diameter) combined with a charged powder called "toner" or toner particles 38 (i.e., charged with the opposite sign of the charges 17 on the photoconductor drum 10). These toner particles are charged by tribo-electrification (i.e., charging by friction). As shown, a combination of a developer drum 30, a developer bias source 31, and a feeder drum 32, and the interaction of the toner particles with the carrier bead surface, may be used to charge the toner particles by tribo-clectrification and cause the toner particles to stick to the carrier bead surfaces. As the surface of the developer drum 30 rotates, its alternating magnetic poles, as shown, remain at the same positions. A metering scraper 36 may be provided adjacent to the developer drum 30 to remove any excess developer mixture, such that a substantially uniform thickness of developer mixture (including the toner particles 38 stuck to the carrier bead surfaces) is provided on the radial surface of the developer drum 30. When the developer drum 30 and the photoconductor drum 10 rotate in opposite directions and at different surface speeds, as shown, the charged toner 38 is transferred off of the carrier beads by attraction onto the electrostatically charged portions of the photoconductive layer 11, to form the toner 38' in a desired pattern on the photoconductor drum 10. Alternate development methods which do not require carrier beads include powder cloud development, electrostatic transport of the toner within the developer subsystem, and liquid development, as well known in the EP art. In the liquid development system, the solid particles in the liquid developer mixture are substantially dry by the time they are transferred to the substrate (see FIGURE 4). Details of the developer subsystem construction vary depending on the development method chosen.

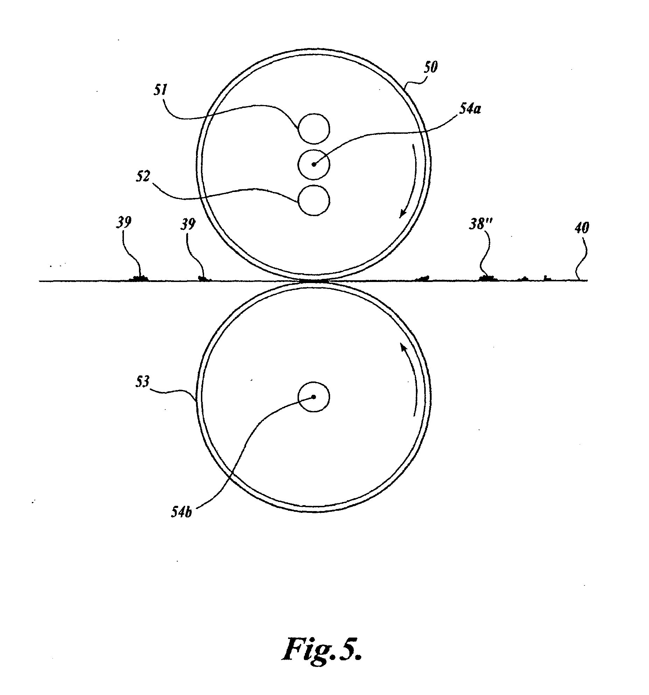

In accordance with various embodiments of the present invention, any conductive, semiconductive, or dielectric materials, which may be polymeric or non-polymeric, and which may he liquid or solid, may be micro-encapsulated or nano-encapsulated to form toner particles suitable for use in the EP process. Such printed electronics materials may include, without limitation, conductive materials such as gold flake, silver flake, nano-silver, or nano-gold, semiconductive materials such as polythiophene, also known as PEDOT, or other suitable copolymers of aniline and pyrrole, and insulative materials such as polyvinyl phenol. The preparation of encapsulated toner particles entails coating very small droplets of printed electronics materials with thin shells of solid material using well-known encapsulation techniques. Encapsulation prevents premature drying of the printed electronics materials (e.g., polymer materials) during the printing process, and also eases their storage. The size preferred for these toner particles is in the 0.3 to 10 micron diameter range. The shell material may be chosen with properties compatible with the EP dry printing process. In other words, any material may be chosen as a shell material as long as its surface roughness, shape, size, tribo-electrification characteristics which allow charging of the encapsulated toner particles, and development and transfer characteristics are suitable for use in EP process. Suitable shell materials may include, without limitation, copolycarbonates, polyesters, styrene copolymers, methacrylates, styrene acrylates, etc. These may have additives for special properties, such as wax additives to prevent sticking to the fusing and curing rollers used to fuse and cure a positive image to a substrate, as will be described later in reference to FIGURE 5.

It should be appreciated that the shell material should also be selected such that during the subsequent fusing and curing step (to be described later in reference to FIGURE 5), it will not interfere with (e.g., alter) the properties of the core printed electronics (e.g., polymer) materials that are encapsulated within the shell material. This may be achieved by choosing the shell material carefully and/or making the shell as thin as possible using known techniques. Another example of a possible method of achieving this is to make the shell(s) of a composite material of nano-particles and one or more binder materials such that the shell material disperses into very small particles during the fusing and curing step. The shells might also be eliminated by mechanical action in a more complicated fusing and curing process. The shell must also not rupture due to normal handling and temperature changes during EP process. It also must not be dissolvable by the core printed electronics (e.g., polymer) material if dissolving it causes interference with the operation of the printed electronics circuit. In some embodiments of the present invention, achieving these characteristics may require two or more layers of encapsulation, e.g. with the outer layer of the shell providing the desired EP properties (e.g., surface roughness, shape, size, tribo-electrification characteristics, etc.) and with the inner layer of the shell providing compatibility with the printed electronics (e.g., polymer) materials and desired mechanical strength.

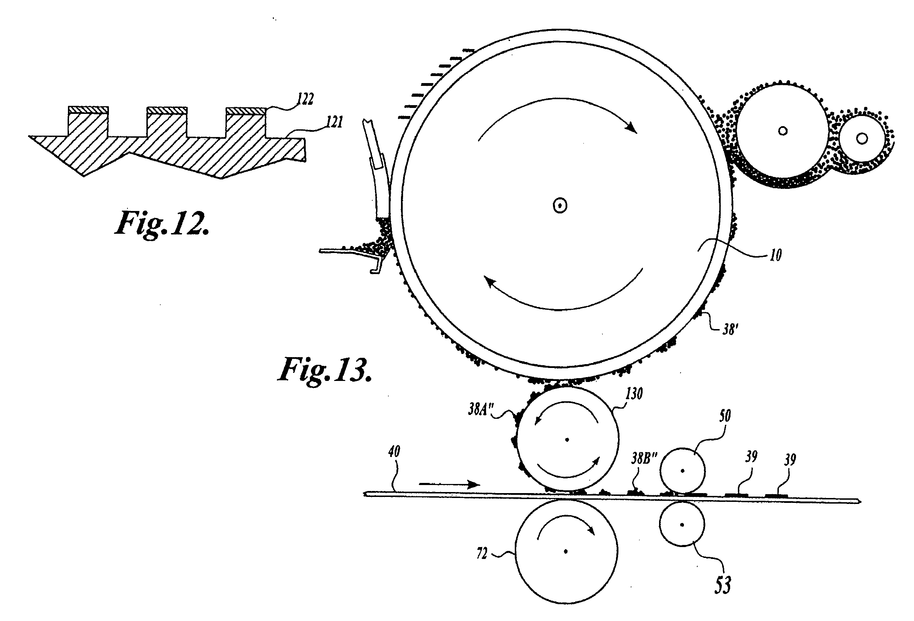

Referring to FIGURE 4, the fourth step of EP involves transferring the positive image (formed of the charged toner) from the photoconductor drum 10 to a surface, such as a substrate 40 on which printed electronic circuits are to be formed. The substrate 40 may be any material providing a surface on which printed electronic circuits may be suitably formed using EP. Such substrates may include, hut are not limited to, uncoated paper, coated paper, laminated paper products, corrugated board, dimension lumber, plywood, glass, various plastic films such as polyethylene or polynaphthalene, and cellulosic films. The substrate 40 may be stiff or flexible depending on each application. Further, while the following describes substrates mainly in the form of a web, it should be understood that substrates may be provided in other forms, such as in the form of discrete sheets (or pieces). In some embodiments of the present invention to be described in detail later in reference to FIGURE 13, the surface to which the positive image is transferred from the photoconductor drum 10 may be a surface of an "intermediate" drum or plate, from which the positive image is further transferred onto a substrate on which printed electronic circuits are formed. Transferring of a positive image from the photoconductor drum 10 to a surface (of a substrate or of an intermediate drum/plate) is achieved by bringing the surface (e.g., the substrate 40 in FIGURE 4) on a transfer roller 72 into contact with the powder layer of the positive image 38' on the photoconductor drum 10. In normal EP practice the transfer roller 72 has a semiconducting elastomer coating, which is prcssed against the photoconducting drum 10 to provide a desired nip pressure. At this point, an attractive electric field is applied to pull the toner 38' off of the photoconductor drum 10 and onto the surface 40, to thereby form a positive image of toner 38" on the surface 40. Without the attractive electric field, most of the toner would remain on the photoconductor drum 10. The electric field is usually applied by charging the transfer roller 72 (which could be a flat surface in some EP embodiments) behind the substrate 40 with a biasing voltage source 44 that has the sign that is opposite the sign of the toner charge (i.e., the same sign as the original photoconductor charge).

Referring to FIGURE 5, the fifth step of EP involves fusing and curing the powder-like positive image of toner 38" to the substrate 40 to thereby produce a fused and cured image 39, which is securely attached to the substrate 40. For example, the toner and substrate maybe heated so that the thermoplastic toner particles are melted to fuse and cure them to the substrate 40. Prior to this step, the positive image of toner 38" is somewhat loosely bound to the surface (e.g., the substrate 40) and can easily be disturbed or rubbed off. As another example, fusing and curing may be carried out using heat and/or pressure. To apply pressure, two rollers 50 and 53 that are loaded against one another by compression springs may be used, for example. In ordinary EP practice the rollers 50 and 53 have elastic heat resistant coatings and are arranged so that there is mechanical interference between the elastic layers to provide suitable fusing and curing pressure in the nip. The substrate 40 is then passed between the rollers 50 and 53. To additionally apply heat, hot roll pressure fusing and curing rollers may be used, wherein one or more rollers are heated from within by heat lamps 51 and 52, such as tungsten quartz lamps. Fusing and curing in a conventional EP printer is carried out by heating the toner and the substrate to about 180 degree C. This high temperature may not be compatible with the printed electronics (e.g., polymer) materials being used to form printed electronic circuits. If this is the case, to adapt the EP printing process to printed electronics fabrication, fusing and curing methods that use a suitable lower temperature should be used. One embodiment of such methods entails applying pressure to break the encapsulating shells and to mechanically attach the encapsulated materials to the substrate (pressure fusing and curing). Another embodiment of such methods entails applying a solvent liquid or gas to the layer of encapsulated toner after it is transferred to the target substrate 40. This solvent would be chosen to dissolve or soften the encapsulating shell without damaging the substrate 40 and further without damaging the circuit-forming properties of the encapsulated printed electronics materials. For successful production of printed electronics, the printed electronics materials used must often be cured or activated by a temperature changing or cycling and/or humidity treatment. For this reason, it may be necessary to replace the fusing and curing rollers (50 and 53 illustrated in FIGURE 5) with a more complicated curing station to carry out the curing or activating process, depending on the specific printed electronics materials being used. Thus, any reference to fusing and curing rollers in the present application should be construed to encompass a wide variety of "curing stations," which are configured to carry out the necessary fusing and curing/activating step depending on each application. For example, a curing station might consist of two or more pairs of temperature controlled rollers, or a chamber or tunnel through which the substrate travels, with controlled temperature along its length, with or without similarly controlled vapor and/or chemical environment. For example, humidity and oxygen or the lack thereof may be controlled.

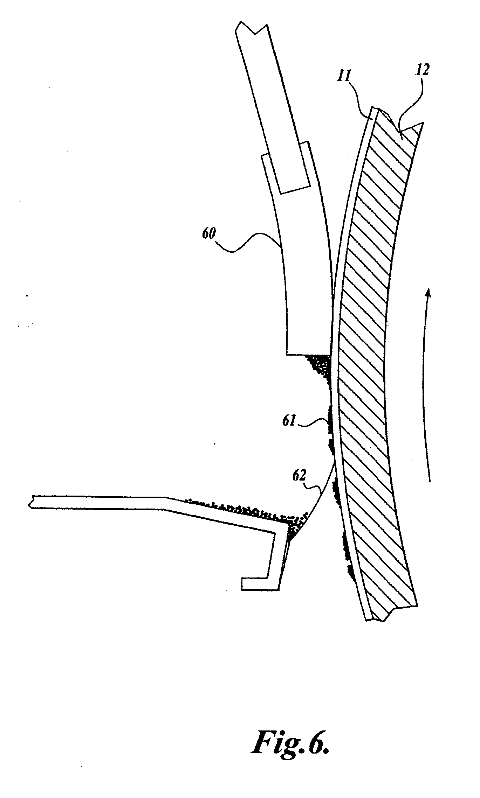

Referring to FIGURE 6, the sixth step of EP involves cleaning the photoconductive drum 10 by removing any un-transferred, un-used toner therefrom, prior to retuning to the first step of EP (FIGURES 1A and 1B) to charge the photoconductor drum 10 for printing the next image. The excess toner particles need to be removed as they will interfere with the corona charging step and also the image exposure step. To this end, a scraper blade 60 (e.g., an elastomer blade) or a rotating brush and vacuum system (not shown) may be used to remove any un-transferred toner 61 from the photoconductor drum 10 and to collect it in a sealed receptacle 62 provided adjacent to the photoconductor drum 1.0.

Referring to FIGURE 7, as in conventional EP printers, the photoconductor may be provided in the form of a rotating photoconductor drum 10, and the six steps described above may be carried out simultaneously, each at a different position around the drum. Specifically, in FIGURE 7, the first step or charging, the second step of imaging, the third step of developing a positive image, the fourth step of transferring, and the sixth step of cleaning may he all performed around the photoconductor drum 10. Further, a transfer roller 72 is provided adjacent to the photoconductor drum 10 in juxtaposition, thereby forming an EP printing nip 74, and suitable curing station rollers 50 and 53 are provided downstream of the EP printing nip 74 to perform the fifth step of fusing and curing. Thus, all six steps of EP process are carried out simultaneously and generally around the photoconductor drum 10, to produce fused and cured images 39 on a substrate 40 that is moved through the EP printing nip 74. In FIGURE 7, an EP print station as a whole is generally designated 70, which consists of the photoconductor drum 10, the transfer roller 72, and the curing station rollers 50 and 53, in the illustrated embodiment.

The photoconductor drum 10 is of a conventional configuration, and includes a support shaft 15 defining the central longitudinal axis of the drum 10, and an outer circumferential support surface adopted to receive the photoconductor layer 1 1 (see FIGURE) 1A). Similarly, the transfer roller 72 is of a conventional configuration including a support shaft 73, which defines the central longitudinal axis of the transfer roller 72, and an outer circumferential elastic semiconducting surface layer to press the substrate 40 against the photoconducting drum 10 with a desired nip pressure and nip width. The curing station rollers 50 and 53 may also be of a conventional configuration including support shafts 54a and 54b defining the central longitudinal axis of the rollers 50 and 53, respectively. The photoconductor drum 10, the transfer roller 72, and the curing station rollers 50 and 53 are mounted for rotation via their respective support shafts on suitable bearings, and are rotationally driven by one or more suitable motors (not shown) via appropriate gearing or belts and pulleys.

It should be appreciated and any or all of the various steps of EP process may also he carried out on flat surface(s), as opposed to around a drum as shown in FIGURE 7.

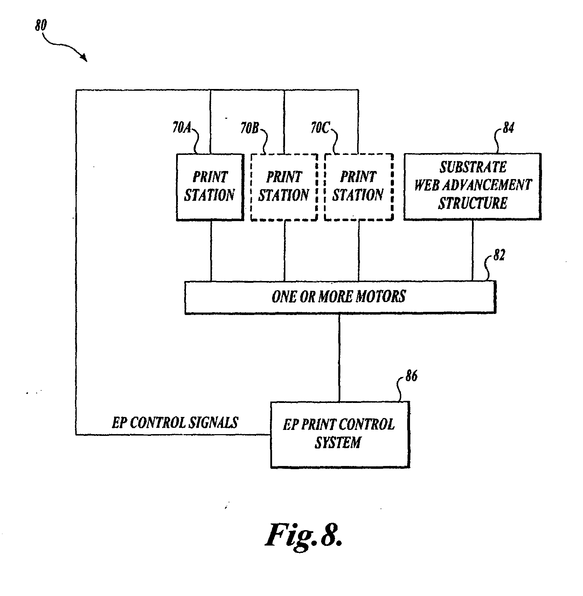

FIGURE 8 is a schematic diagram depicting one exemplary EP printing system, generally designated 80, suitable for producing printed electronic circuits in accordance with some aspects of the present invention. Generally described, the EP printing system 80 includes one or more EP print stations 70A, 70B, 70C, such as the EP print station 70 of FIGURE 7, for each carrying out EP process to form a fused and cured image of printed electronics material as a discrete layer on a substrate. The EP printing system 80 further includes one or more drive motors 82, a substrate web advancement structure 84, and an EP print control system 86 for controlling the overall EP printing process. Generally, the print control system 86 receives inputs from human operator controls, process sensors for temperature, process sensors for motion, laser beam detectors, etc., and sends commands to control adjustable process parameters for the overall EP printing process, such as bias voltages and heater currents, for example. The EP print control system 86 also sends EP control signals to drive each of the EP print stations 70A-70C, and also controls the operation of the one or more motors 82 so as to activate (e.g., rotate) various mechanisms (drums, cylinders, plates, etc.) included in the EP print stations 70A-70C as well as in the substrate web advancement structure 84.

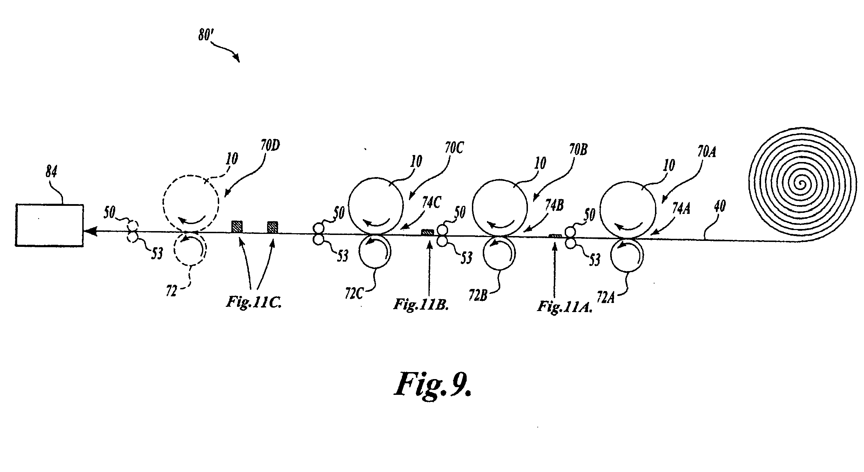

FIGURE 9 schematically illustrates one embodiment of the EP printing system 80' of FIGURE 8. The EP printing system 80' includes a plurality of EP print stations 70. In FIGURE 9, three EP print stations 70A-70C arc shown, and further EP print stations may be added depending on cach application, such as an EP print station 70D shown in phantom. The EP print stations 70A-70C are each comprised of a photoconductor drum 10 (along with it associated components for exposure, development, cleaning, etc.), a transfer roller 72A-72C, and curing station rollers 50 and 53.

It will be appreciated that the printing system 80' may contain other components not shown for case of illustration. For example, the printing system includes a frame to which the working components arc functionally connected. The frame may be any variety of structural members that are assembled together to hold, support, etc. the various components and may be generally by construed of steel frame members welded, riveted, bolted, or otherwise connected together. It will also be appreciated that other physical configurations for a printing system are possible and may be desirable, such as an EP printing system that provides a curved or circular path for the substrate 40.

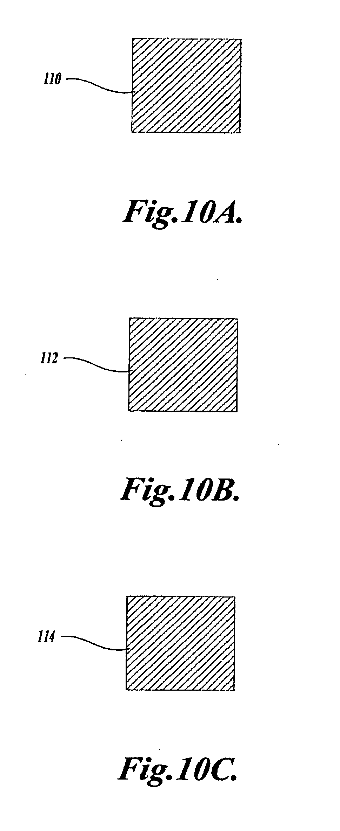

In one embodiment, the EP print stations 70A-70C may be configured to produce fused and cured images 110, 112, and 114 of FIGURES 10A-10C, respectively, on the substrate 40. Specifically, during the second step of EP process (see FIGURE 2), the print stations 70A-70C form electrostatically charged areas having the shapes of 110, 112, and 114, respectively, on which the charged toner particles are attached or deposited. The charged particles deposited in the shapes of 110, 112, and 114 are then sequentially transferred and fused and cured to the substrate 40 as additive layers, each discretely formed by EP process, to thereby construct a capacitor.

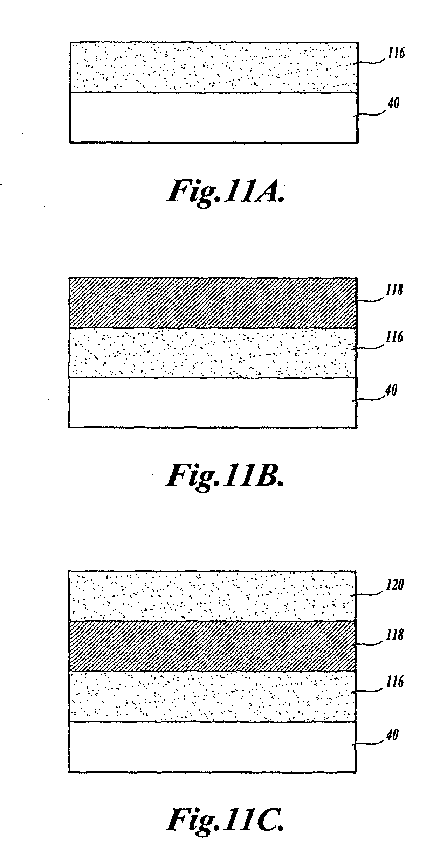

Specifically, a web of substrate 40 is fed through printing system 80', i.e., through the printing stations 70A-70C, between the photoconductive drum 10 and the transfer roller 72 and then between the fusing and curing (or curing station) rollers 50 and 53 at each of the printing stations 70A-70C, and is coupled to a substrate web advancement structure 84 (see FIGURE 8) such as a take-up spool. When the EP print control system 86 is ready to print the desired printed electronic device (e.g., a capacitor), the EP print control system 86 sends appropriate signals to the EP print stations 70A-70C, and to the one or more motors 82 for rotating the photoconductor drums 10, the transfer rollers 70A-70C, and the curing station rollers 50 and 53 of the EP print stations 70A-70C. The one or more motors 82 are also used to power the substrate web advancement structure 84 for advancing the substrate 40 through the first EP printing nip 74A of the first EP print station 70A. As the substrate 40 is advanced through the first printing nip 74A between the photoconductor drum 10 and the transfer roller 72A, and then between the curing station rollers 50 and 53 of the first print station 70A, a fused and cured image having the shape of 110 in FIGURE 10A is formed on the substrate 40. In one embodiment, the fused and cured image 110 is formed using toner made of conductive material, such as gold, and is approximately 50 nanometers thick. Thus, the first EP print station 70A produces an EP-printed image layer 116 on the substrate 40, as shown in FIGURE 11A. As explained earlier, it may be necessary to replace the fusing and curing rollers as illustrated in FIGURE 5 with a more complicated curing station to carry out the curing or activating process depending on the specific printed electronics materials being printed.

The section of the substrate 40 now having the first EP-printed image layer 116 thereon is advanced to the second EP print station 70B, where a second EP-printed layer 118 is formed on the first EP-printed layer 116, as shown in FIGURE 11B. It will be appreciated that the second EP print station 70B operates in substantially the same manner as the first EP print station 70A, such that upon proper signals from the EP print control system 86, the second fused and cured image of 112 in FIGURE 10B is applied over the first EP-printed image layer 116 to thereby form the second EP-printed layer 118 when the substrate 40 passes through the second EP printing nip 74B. In one embodiment, the second fused and cured image 112 is formed using toner made of insulative material, such as polyvinyl phenol, and is approximately 200 nanometers thick.

The section of the substrate 40 now having the first and second EP-printed image layers 116 and 118 thereon is advanced to the third EP print station 70C, where the EP process is applied to form a third fused and cured image 114 of FIGURE 10C to thereby create a third EP-printed image layer 120 on the second EP-printed image layer 118, as shown in FIGURE 11C. In one embodiment, the third fused and cured image 114 is formed using toner made of conductive material, such as silver, and is approximately 100 nanometers thick. The resulting product in the illustrated example, as best shown in FIGURE 11C, is a capacitor formed on the substrate 40, including an insulator layer 118 sandwiched between two conductive layers 116 and 120.

If electronic devices having more than three layers are desired to be fabricated, any number of additional EP print stations 70 may be added for printing the appropriate material and the desired image(s) onto the aggregate layers.

It will be appreciated that the printing system 80' may be configured to carry out additional processes other than those explicitly shown in the illustration. For example, a curing station of any of the EP print stations may additionally perform the process of encapsulating a layer or layers formed on the substrate, to protect the layer(s) from moisture, external material, etc. In some applications, each layer may be selectively encapsulated, so that only a selected portion or portions of the layer are encapsulated while other portions remain exposed, which may then be coupled to leads or connected to an adjacent layer, for example. Alternatively or additionally, an independent encapsulation station (not shown) may be provided downstream of all EP print stations, so as to carry out the encapsulation step for the printed electronics devices as completed by the EP print stations.

While fabrication of a capacitor was illustrated and described herein, other electronic devices may he fabricated using the methods and systems described herein. For example, it will be appreciated that by the selection of the materials to be deposited, the image formed at each EP print station, the sequential order of the EP-printed image layers, and the number of EP print stations, any of a number of electronic devices may be fabricated. Several examples of electronic devices or possible circuits composed of these devices include, but are not limited to, resistors, capacitors, inductors, transistors, diodes, rectifiers, oscillators, memory, chemical sensors, electrical sensors, temperature sensors, humidity sensors, pressure sensors, motion sensors, pH sensors, displays, speakers, I/O panels, clocks, electroluminescent lamps, solar cells, infrared cells, radios, etc.

In one non-limiting embodiment, a transistor may be formed with a printing system having four EP print stations, for respectively forming four EP sequential layers of: (1) conductor (e.g., gold), (2) semiconductor (e.g., PEDOT), (3) insulator or dielectric (e.g., polyvinyl phenol), and (4) conductor (e.g., silver).

In many applications of printed electronics, an EP-based method and system may be used to produce very large numbers of identical circuits. For these applications, a further modified EP process may be used. For example, referring to FIGURE 12, as an electrostatically chargeable surface, instead of a photoconductor drum (or plate), a non-photoconductive drum or plate including a photolithographically produced surface topography 121, on which dielectric coating 122 is applied, may be used. In photolithography, a conventional one micron diameter laser beam may be used to image a photo-resistive plate material, and conventional subtractive processes could be used to chemically etch away non-image areas, to thereby yield a surface topography in high precision. The top surfaces of the elevated sections or mesas produced by photolithography arc then coated with a dielectric insulating material. These top surfaces define images to be EP-printed. Specifically, the dielectric-coated areas 122 are then charged, using a step similar to the first step of EP process described above in reference to FIGURES 1A and 1B, and the third through six steps of EP process described in reference to FIGURES 3-6 are performed to EP-print the images defined by the dielectric-coated top surfaces 122. The areas other than the top surfaces 122 are not dielectric-coated and thus arc not charged. Note that in this embodiment the second step of conventional EP process directed to exposing a charged photoconductor to light to form a latent image may be omitted, thereby providing a simpler printing mechanism, since the image areas to be EP-printed are explicitly defined by the dielectric-coated top surfaces of the drum or plate. Also, this embodiment provides the advantage that the high precision surface topography determines the edges of the printed areas with higher accuracy than the normal EP process.

In other applications, instead of the dielectric coating. a photoconductor coating may be applied to the top surfaces of the elevated sections or mesas produced by photolithography. These photoconductor-coated areas 122 then define images to be EP-printed. Specifically, the photoconductor-coated areas 122 are charged, using the first step of EP process described above, and the third through sixth steps of EP processes described above are performed to EP-print the images defined by the photoconductor-coated areas 122. Again, in these applications, the second step of conventional EP process directed to exposing a charged photoconductor to light to form a latent image may be omitted.

In still other applications, the use of a photoconductor drum or plate and the use of a photolithographically produced topography (with a dielectric or photoconductor coating) may be combined, such that portions of an electronic circuit device to be printed may be formed using the photoconductor drum or plate, while other portions of the same device may be formed using the photolithographically produced topography. For example, chosen parts of the printed electronics circuit may be dynamically modified under computer control of the photoconductor exposure (in the second step of EP process, as in FIGURE 2) to create options or variations of the circuit, while the other (e.g., core) desired parts of the circuit pattern may be defined with high precision edges by surface topography. In this way, advantages of both methods may he combined--the advantages of the photoconductor-hased method allowing plate-less dynamic imaging, and the advantages of the topography-based method allowing high-resolution high-precision imaging.

FIGURE 13 illustrates an additional embodiment of the present invention, which uses an intermediate surface 130 (provided by an intermediate drum 130 in the illustrated embodiment) arranged between an electrostatically chargeable surface (e.g., the photoconductor drum 10 or a dielectric-coated surface topography) and a transfer roller 72. In this embodiment, the developed EP toner image is first transferred from the electrostatically chargeable surface (e.g., the photoconductor drum 10) to the intermediate drum or surface 130. The transferred toner image 38"A is then transferred again from the intermediate drum or surface 130 to the final target substrate 40 which, in the illustrated embodiment, is supported by the transfer roller 72. As before, the transferred toner image 38"B on the substrate 40 is then fused and cured with the substrate 40, using the curing station rollers 50 and 53 for example, to thereby produce a fused and cured image 39 on the substrate 40. The use of an intermediate surface 130 may provide relief from various mechanical and EP design constraints, such as mechanical incompatibility of the EP photoconductor with the final target substrate 40, or to prevent wear of the photoconductor or to prevent contamination of EP process by the target substrate material.

The intermediate drum or surface 130 can also be provided with a dielectric-coated surface topography using photolithography, as described above. In this embodiment, the photoconductor drum (or plate) 10 or a dielectric-coated drum (or plate) is used as an "inking" drum, which fully develops an encapsulated toner layer over its entire surface. The surface topography of the intermediate drum (or plate) 130, produced based on photolithography, would then provide the printing pattern. Specifically, encapsulated toner would not transfer to valley areas of the intermediate surface 130 because the toner would come into contact only with the lands (raised areas) of the intermediate drum during the transfer of the encapsulated toner layer from the photoconductor (or dielectric-coated) drum to the intermediate drum. In this embodiment also, the second step of EP process involving patterned exposure of an image is not necessary, to thereby provide a simpler printing mechanism and higher precision edges for the printed pattern.

It should be appreciated by one skilled in the art familiar with EP process that all steps of EP printing process can be performed with flat photoconductors or dielectric-coated surfaces (produced by photolithography) and/or a flat intermediate surface and/or a final substrate, and/or in discrete steps instead of simultaneously with rotating drum(s) as described above. The use of such flat surfaces in EP process may enable very high-precision printing registration from layer to layer, which may he necessary to produce some printed electronic circuits. Such high-precision registration may be achieved using standard mechanical methods and/or with high precision Fiducial marks and active feedback nano-positioning.

Accordingly, the present invention provides various methods and systems for producing printed electronic circuits using electrophotography. The methods and systems are particularly suited for producing low-power electronic circuits at very low cost (e.g., on the order of about one tenth of the cost of producing analogous integrated circuits), such as RFID tags to be placed in or on an item or its container (i.e., item-level labeling or tagging). Other applications include flexible displays, "smart" documents, smart skin patches for medical delivery or sensing, patient compliance monitors, disposable calculators, etc.

While illustrative embodiments have been illustrated and described, it will he appreciated that various changes can be made therein without departing from the spirit and scope of the invention.

## Claims

1. A method for printing an electronic device onto a substrate using electrophotography (EP), comprising:
providing a surface;
routing the surface through a sequential series of EP print stations, each of the EP print stations comprising an electronically chargeable drum or plate and at least a portion of one surface support structure, wherein each electrostatically chargeable drum or plate defines a positive image formed of charged particles; and
sequentially transferring the positive images defined on the electrostatically chargeable drums or plates of the series of EP print stations onto the surface, wherein each of the positive images represents a discrete image layer for forming the electronic device.

2. A method as claimed in claim 1, wherein the charged particles comprise a micro- or nano-encapsulated material.

3. A method as claimed in claim 2, wherein the micro- or nano-encapsulated material is selected from a group consisting of conductive materials, semiconductive materials, and insulative materials.

4. A method as claimed in claim 2, wherein the micro- or nano-encapsulated material is a polymer material.

5. A method as claimed in any of claims 1 to 4, wherein the surface comprises a substrate on which the printed electronic device is formed.

6. A method as claimed in claim 5, wherein the substrate is selected from a group consisting of uncoated paper, coated paper, laminated paper, corrugated board, dimension lumber, plywood, glass, plastic film, and cellulosic film.

7. A method as claimed in any of claims 1 to 6, wherein the surface comprises an intermediate surface from which each positive image is further transferred onto a substrate on which the printed electronic device is formed.

8. A method as claimed in any of claims 1 to 7, wherein the electrostatically chargeable drum or plate is formed of photoconductor.

9. A method as claimed in any of claims 1 to 7, wherein the electrostatically chargeable drum or plate comprises a dielectric-coated surface topography formed by photolithography.

10. An electrostatic device printed on a substrate by the method of any of claims 1 to 9.

11. A system for print an electronic device onto a substrate using electrophotography (EP), comprising:
a series of EP print stations, each EP print station comprising an electrostatically chargeable drum or plate and at least a portion of one surface support structure, wherein each electrostatically chargeable drum or plate defines a positive image formed of charged particles, each positive image representing an image layer that forms the electronic device;
one or more motors for powering the electrostatically chargeable drums or plates of the series of EP print stations; and
an EP print control system that controls the plurality of EP print stations and the one or more motors, so as to route a surface through the series of EP print stations to sequentially transfer the positive images defined on the electrostatically chargeable drums or plates of the series of EP print stations onto the surface.

12. A system as claimed in claim 11, wherein the surface comprises a substrate on which the printed electronic device is to be formed.

13. A system as claimed in claim 11 or claim 12, wherein the surface comprises an intermediate surface, form which each positive image is further transferred onto a substrate on which the printed electronic device is to be formed.

14. A system as claimed in claim 13, wherein the intermediate surface comprises an intermediate drum or an intermediate plate.

15. A system as claimed in any one of claims 11 to 14, wherein the surface support structure comprises a transfer roller or a platen.

16. A system as claimed in any one of claims 11 to 15, wherein the electrostatically chargeable drum or plate is formed of photoconductor.

17. A system as claimed in any one of claims 11 to 15, wherein the electrostatically chargeable drum or plate comprises a surface topography formed by photolithography which has a dielectric coating.

18. A system as claimed in any one of claims 11 to 15, wherein the electrostatically chargeable drum or plate comprises a surface topography formed by photolithography which has a photoconductor coating.

19. A method for printing a plurality of print layers using electrophotography (EP) comprising:
(a) routing a surface to a first EP print station, wherein the first EP print station comprises a first electrostatically chargeable drum or plate and at least a portion of one surface support structure, and the first electrostatically chargeable drum or plate defines a first positive image formed of charged particles;
(b) transferring the first positive image defined on the first electrostatically chargeable drum or plate of the first EP print station onto the surface;
(c) routing the surface to a second EP print station, wherein the second EP print station comprises a second electrostatically chargeable drum or plate and at least a portion of one surface supports structure, and the second electrostatically chargeable drum or plate defines a second positive image formed of charged particles; and
(d) transferring the second positive image defined on the second electrostatically chargeable drum or plate of the second EP print station onto the surface.

20. A method as claimed in claim 19, wherein the surface comprises a substrate on which the first positive image is transferred, and the second positive image is transferred onto at least a portion of the first positive image on the substrate.

21. A method as claimed in claim 19 or claim 20, further comprising:
(a) routing the surface to a third EP print station, wherein the third EP print station comprises a third electrostatically chargeable drum or plate and at least a portion of one surface support structure, and the third electrostatically chargeable drum or plate defines a third positive image formed of charged particles; and
(b) transferring the third positive image defined on the third electrostatically chargeable drum or plate of the third EP print station onto the surface.
